(19) Europäisches Patentamt
European Patent Office
Office européen des brevets

(11) EP 1 416 596 A1

(12) EUROPEAN PATENT APPLICATION

(43) Date of publication:
**06.05.2004 Bulletin 2004/19**

(51) Int Cl.[7]: **H01S 5/022**

(21) Application number: **03024388.5**

(22) Date of filing: **24.10.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **29.10.2002 JP 2002314620**

(71) Applicant: **NEC Compound Semiconductor Devices, Ltd.**
**Kawasaki-shi, Kanagawa (JP)**

(72) Inventors:
- **Kurihara, Yusuke**
  **Nakahara-ku Kawasaki-shi Kanagawa (JP)**
- **Ito, Akihiro**
  **Nakahara-ku Kawasaki-shi Kanagawa (JP)**
- **Mukaihara, Kazushige**
  **Nakahara-ku Kawasaki-shi Kanagawa (JP)**
- **Shimizu, Junichi**
  **Nakahara-ku Kawasaki-shi Kanagawa (JP)**

(74) Representative:
**von Samson-Himmelstjerna, Friedrich R., Dipl.-Phys. et al**
**SAMSON & PARTNER**
**Widenmayerstrasse 5**
**80538 München (DE)**

(54) **Semiconductor laser module**

(57) A laser module comprises a laser diode (21) secured on a semiconductor substrate (20) for emission of a forward laser beam from its front end and a backward laser beam from a point source on its rear end in a horizontal direction. A photodiode (22), also secured on the substrate (20), has a light receiving surface extending in the horizontal direction by length L from an edge proximate to the laser diode (21) for receiving a lower half of the backward laser beam, the light receiving surface being lower than the point source (S) by a vertical distance Y, the edge being spaced a horizontal distance Z from the point source of the laser diode, wherein the horizontal distance Z is equal to or greater than (Y/ tan θ) - L, where θ is a vertical angle in which the lower half of the backward laser beam radiates from the point source (S).

FIG. 2

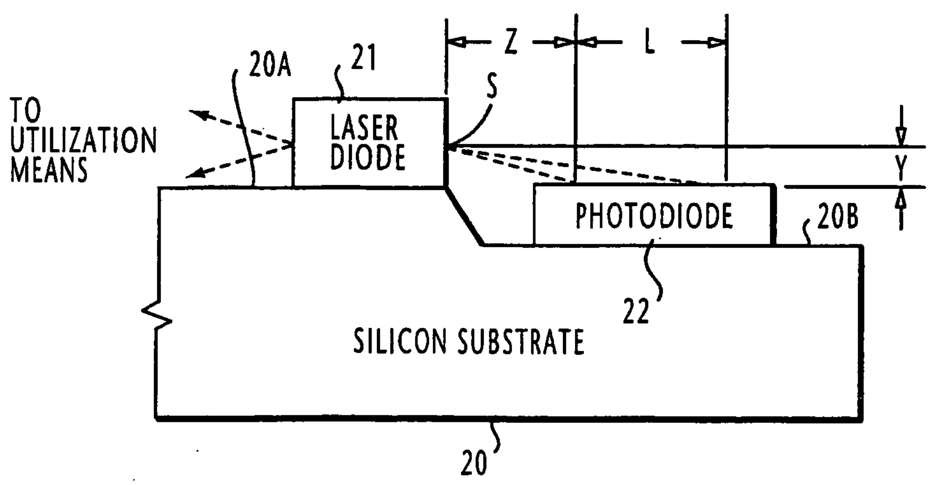


EP 1 416 596 A1

**Description**

BACKGROUND OF THE INVENTION

Field of the Invention

The present invention relates to a semiconductor laser module in which a photodiode is provided for monitoring the operation of a laser diode by observing its backward emission.

Description of the Related Art

In a semiconductor laser module as described in Japanese Patent Publication No. 2000-269584, (see Fig. 1), a silicon substrate 10 has a part of its major surface anisotropically etched to create a stepped lower level. A laser diode 11 is formed on the major surface of the substrate for the emission of a forward laser beam from its front end and a backward laser beam from its rear end. An optical fiber 13 is secured on the substrate to receive the forward laser beam through a lens system 14. A monitoring photodiode 12 is secured on the lower level of the substrate proximate to the rear end of laser diode 11. The module is covered with a transparent resin mold 15 which is coated with a reflecting film 16. A portion of the resin mold 15 that is formed on the photodiode 12 is so curved that the backward laser beam is internally reflected off the curvature of the reflecting film to the light receiving surface of the photodiode 12. The output current of the photodiode is observed to monitor the operation of the laser diode.

Therefore, the curvature of the resin mold is a critical factor for determining the amount of laser beam incident on the light receiving surface of the photodiode. However, difficulty exists in consistently forming resin molds having a predetermined curvature. This results in variability of curvature among different products, causing monitoring photodiodes to produce output currents which differ significantly from one laser module to another. Precision molding of resin was required at the cost of low yield.

Japanese Patent Publication No. 1998-22576 discloses a laser module in which the module is covered with resin mold and the forward laser beam of a laser diode is reflected off a skewed surface and emanated at right angles through the resin mold to the outside. Resin mold is used for the purpose of rigidly integrating and holding all elements of the module in proper fixed positions relative to each other. The backward laser beam illuminates a photodiode which is located in a position adjacent the laser diode. However, the resin mold has irregular surface contour which causes the backward light to bounce off randomly. Such reflections may hit the light receiving surface of the photodiode, causing it to produce an output current different from the rated value. Further, there is an inevitable of loss of light due to the limited light transmissivity of the resin with which the photodiode is covered. The provision of resin mold itself represents the potential cause of low yield. It is desirable that the laser module is not covered with a resin mold.

In addition, the prior art resin-covered laser module suffers from another problem associated with a laser driver that drives the laser diode with a high frequency information signal. Since the laser module is substantially covered with a resin mold, the laser driver is located outside of the covered elements Hence, long bonding wires are required to supply high frequency current from the laser driver to the laser diode. Due to the long bonding wires, the high frequency information signal suffers from attenuation as well as from waveform distortion, thus making it difficult to ensure satisfactory light modulation performance.

SUMMARY OF THE INVENTION

It is therefore an object of the present invention to provide a semiconductor laser module which can be manufactured with high yield at a reduced cost.

Another object of the present invention is to provide a semiconductor laser module in which a laser driver is provided to enable the laser diode to operate with sufficient energy of high frequency information signal to exhibit satisfactory light modulation performance.

According to the present invention, there is provided a semiconductor laser module comprising a semiconductor substrate, a laser diode secured on the substrate for emission of a forward laser beam from a forward end thereof and for emission of a backward laser beam from a point source on a rearward end thereof in a horizontal direction; and a photodiode secured on the substrate, the photodiode having a light receiving surface extending in the horizontal direction by length L from an edge proximate to the laser diode for receiving a lower half of the backward laser beam, the light receiving surface being lower than the point source by a vertical distance Y, the edge being spaced a horizontal distance Z from the point source of the laser diode, wherein the horizontal distance Z is equal to or greater than $(Y/\tan\theta) - L$, where $\theta$ is a vertical angle in which the lower half of the backward laser beam radiates from the point source.

Preferably, the laser diode and the photodiode are not covered with resin. The substrate may be formed with an upper surface and a lower surface, and the laser diode is secured on the upper surface and the photodiode is secured on the lower surface.

BRIEF DESCRIPTION OF THE DRAWINGS

The present invention will be described in detail further with reference to the following drawings, in which:

Fig. 1 is a side view of a prior art semiconductor laser module;

Fig. 2 is a side view of a semiconductor laser module according to the present invention;

Figs. 3A and 3B are plan and side views, respectively, of the laser module of the present invention for illustrating dimensional relationships between the laser diode and the photodiode; and

Fig. 4 is a graphic representation of the output current of the photodiode as a function of the separation between the emission point of backward laser beam and the light receiving surface of the photodiode when the proximal edge of the light receiving surface is spaced a distance 200 micrometers from the emission point of the backward laser beam;

Fig. 5 is a plan view of a semiconductor laser module in which a laser driver is provided; and

Fig. 6 is a cross-sectional view taken along the line 6-6 of Fig. 5.

DETAILED DESCRIPTION

Referring now to Fig. 2, there is shown a semiconductor laser module of the present invention. The present invention eliminates the need to provide a transparent resin mold for reflecting the backward laser beam. Without using the resin mold, the manufacturing steps of laser modules are reduced and their yield is significantly improved.

The laser module of this invention comprises a single-crystalline silicon substrate 20, a laser diode 21 and a photodiode 22. Part of the substrate 20 is anisotropically etched along its (100) crystal plane to form a lower surface 20B stepped down from the major surface 20A. Laser diode 21 is secured on the major surface 20A and the photodiode 22 on the lower surface 20B.

Laser diode 21 provides emission of a forward laser beam from a first point source on its front end and emission of a backward laser beam from a second point source S on its rear end. The forward laser beam is utilized by an external utilization means, not shown. As illustrated in detail in Figs. 3A and 3B, the photodiode 22 has a flat light receiving surface 30 which is illuminated directly with an incident backward laser beam 31 from the point source S. The light receiving surface 30 may take any of the square, rectangular, circular and elliptical shapes.

Prior to the anisotropic etching, the vertical position of lower surface 20B is determined with respect to the point source S so that the light receiving surface 30 is positioned at a level lower than the point source S by a vertical distance Y. Light receiving surface 30 has a front edge 32 which is spaced a distance Z from the rear end of the laser diode 21 and has a length L from the front edge 32. Backward laser beam 31 is emitted so that it forms a light spot which subtends a horizontal angle 2$\phi$ as viewed from above (Fig. 3A) and a vertical angle 2$\theta$ as viewed from sideways (Fig. 3B). In order to produce a sufficient monitor current from the photodiode 22, the light receiving surface 30 is subjected to the lower half of the backward laser beam from the point source S if the following relation holds:

$$Z \geq \frac{\Upsilon}{\tan\theta} - L \qquad (1)$$

where, $\theta$ is the vertical angle of the lower half of the backward laser beam.

Fig. 4 shows a result of experiments when the output current of photodiode 22 was measured when the distance Z is fixed at 200 μm and the vertical distance $\Upsilon$ is varied in the range from 40 μm to 160 μm. A peak current of approximately 210 μA was obtained when the vertical distance $\Upsilon$ was equal to 120 μm. The current value of 210 μA is sufficient for monitoring purposes.

Fig. 5 shows a semiconductor laser module provided with a laser driver 40. In this embodiment, the silicon substrate 20 is covered with a photomask (not shown) having a pattern of the photodiode 20 and laser driver 40 and anisotropically etched through the mask to a specified depth where the lower surface 20B appears (see Fig 6). Photodiode 22 is secured on the lower surface 20B and the laser driver 40 is also secured on the same surface in a position adjacent to the photodiode 22 and remote from the laser diode 21. A pair of patterned electrodes 41 are laid out on the upper surface 20A, extending lengthwise from opposite sides of the laser diode 21 past the photodiode 22 to positions close to the laser driver 40. A pair of bonding wires 42 are used to connect the laser driver 40 to the patterned electrodes 41 to supply high frequency information signals from the laser driver 40 to the laser diode 21. Since the ends of the conducting electrodes are close to the laser driver 40, the bonding wires 42 can be made as short as possible. As a result, the high frequency information signal supplied from the laser driver 40 to the laser diode 21 suffers from less attenuation and less distortion compared to the prior art. Therefore, the laser diode 21 is supplied with sufficient energy of high frequency electrical signal to exhibit satisfactory light modulation characteristics.

**Claims**

**1.** A semiconductor laser module comprising:

a semiconductor substrate;

a laser diode secured on said substrate for emission of a forward laser beam from a forward end thereof and for emission of a backward laser beam from a point source on a rearward end thereof in a horizontal direction; and

a photodiode secured on said substrate, said photodiode having a light receiving surface extending in the horizontal direction by length L from an edge proximate to the laser diode for receiving a lower half of said backward laser beam, said light receiving surface being lower than said point source by a vertical distance ϒ, said edge being spaced a horizontal distance Z from said point source of the laser diode,

wherein the horizontal distance Z is equal to or greater than (ϒ/ tan θ) - L, where θ is a vertical angle in which said lower half of the backward laser beam radiates from said point source.

**2.** The semiconductor laser module of claim 1, wherein said laser diode and said photodiode are not covered with resin.

**3.** The semiconductor laser module of claim 1, wherein said substrate has an upper surface and a lower surface, and wherein said laser diode is secured on said upper surface and said photodiode is secured on said lower surface.

**4.** The semiconductor laser module of claim 2, wherein said lower surface and said light receiving surface are parallel to each other.

**5.** The semiconductor laser module of claim 1, wherein said semiconductor substrate is formed of silicon.

**6.** The semiconductor laser module of claim 1, wherein said substrate is formed of a single-crystalline silicon and said lower surface is an anisotropically etched surface.

**7.** The semiconductor laser module of claim 1, further comprising a laser driver for driving the laser diode with a high frequency electrical signal.

**8.** The semiconductor laser module of claim 7, wherein said laser driver is secured on said lower surface in a position adjacent to said photodiode and remote from said laser diode.

**9.** The semiconductor laser module of claim 8, wherein said substrate is formed with a recess in which said lower surface is created and said photodiode and said laser driver are secured, further comprising:

an electrode patterned on said upper surface extending from said laser diode to a position close to said laser diode; and
a bonding wire for connecting said laser diode to one end of said electrode, whereby said high frequency electrical signal is supplied through said bonding wire and said electrode to said laser diode.

FIG. 1

PRIOR ART

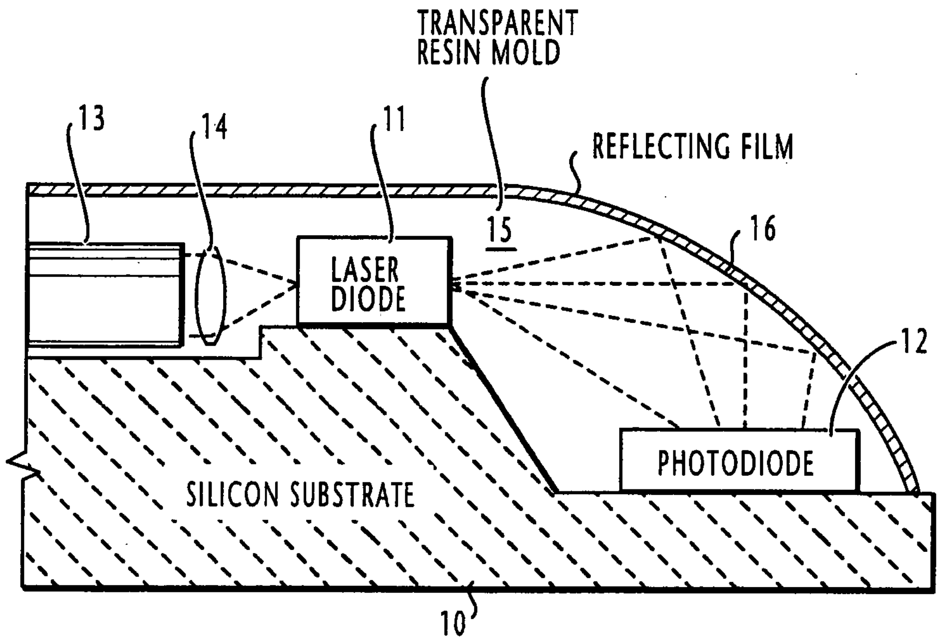


FIG. 2

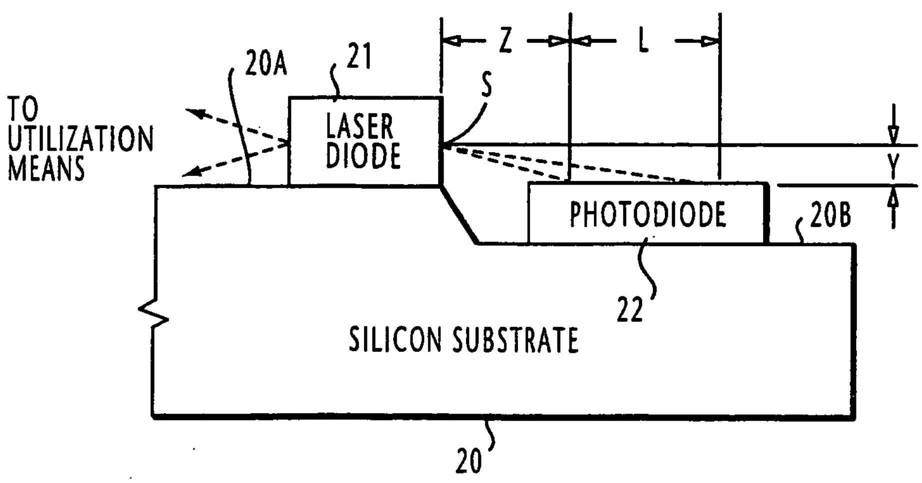

FIG. 3A

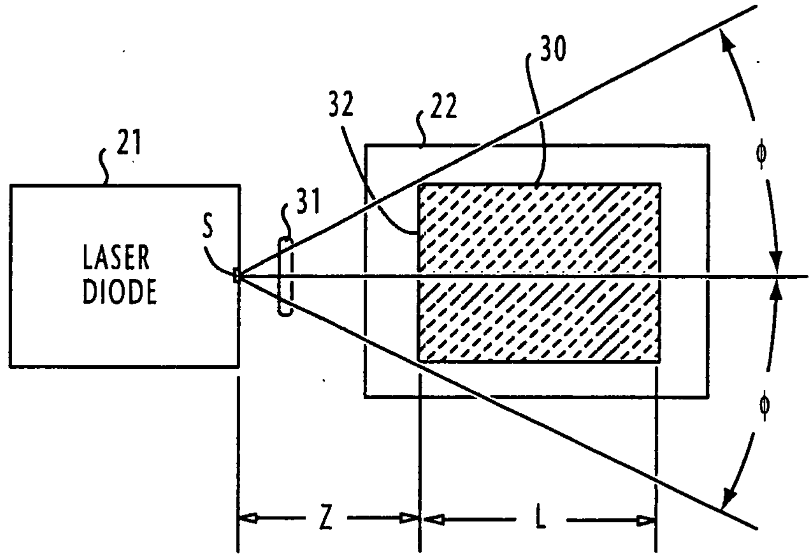
30
32
22
21
31
S
LASER DIODE
ϕ
ϕ
Z
L

FIG. 3B

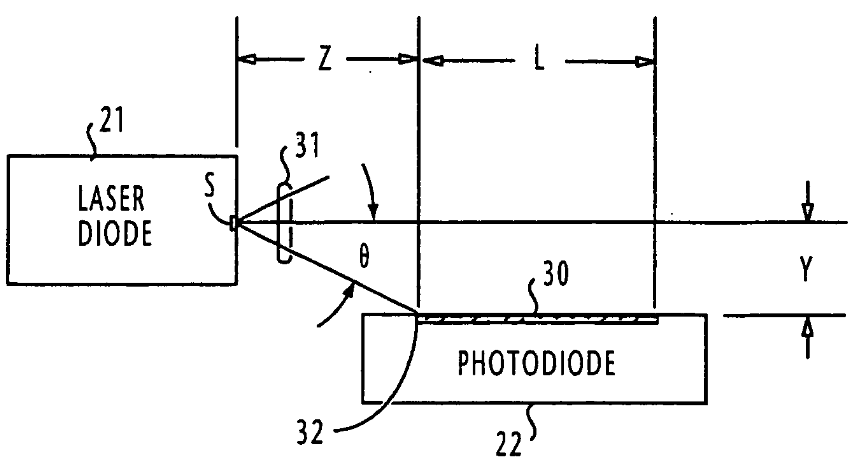
Z
L
21
31
S
LASER DIODE
θ
30
Y
PHOTODIODE
32
22

FIG. 4

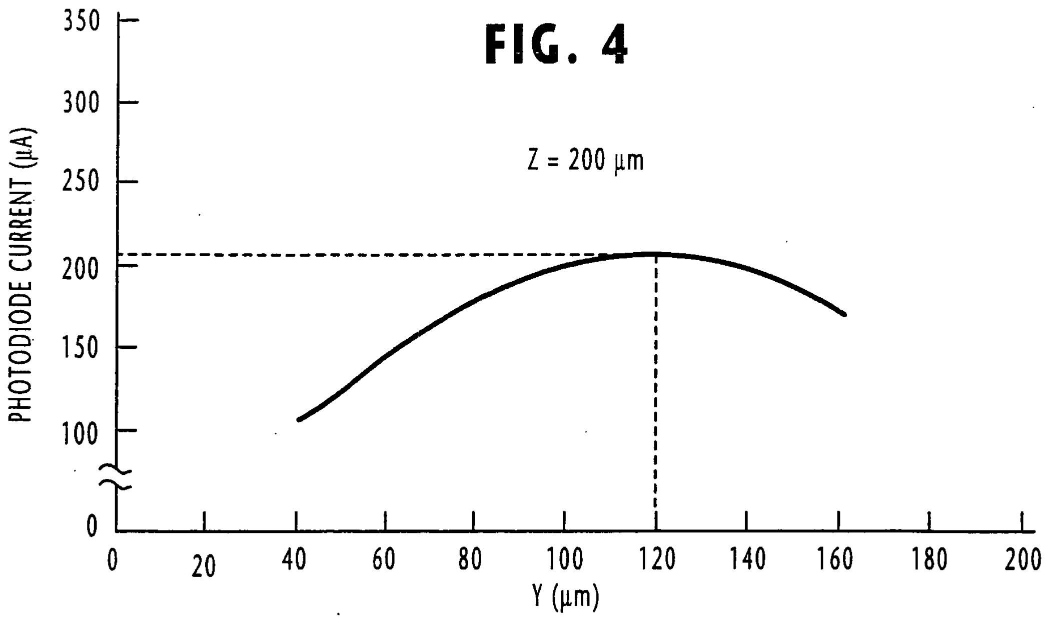


FIG. 5

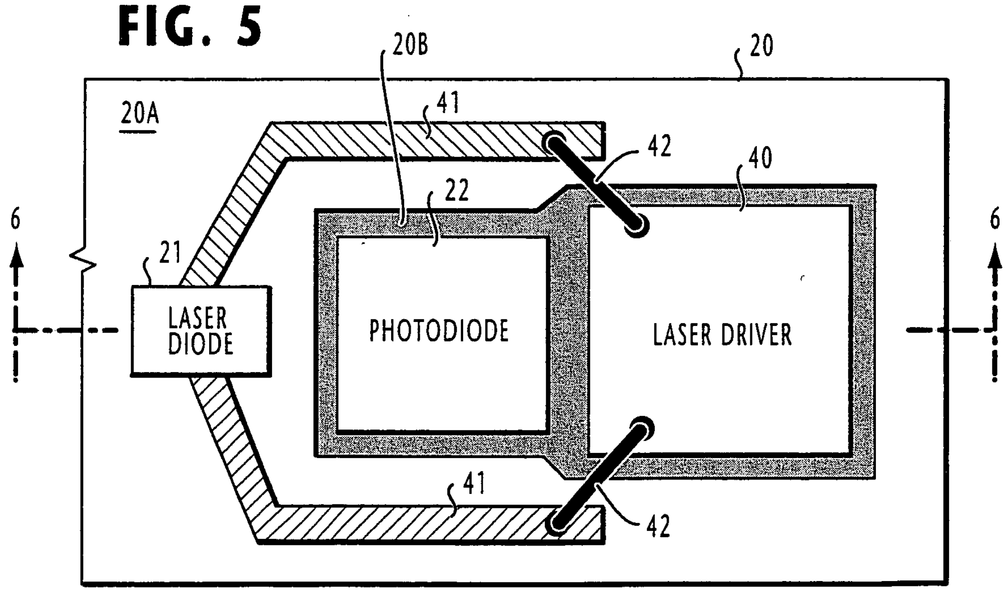


FIG. 6

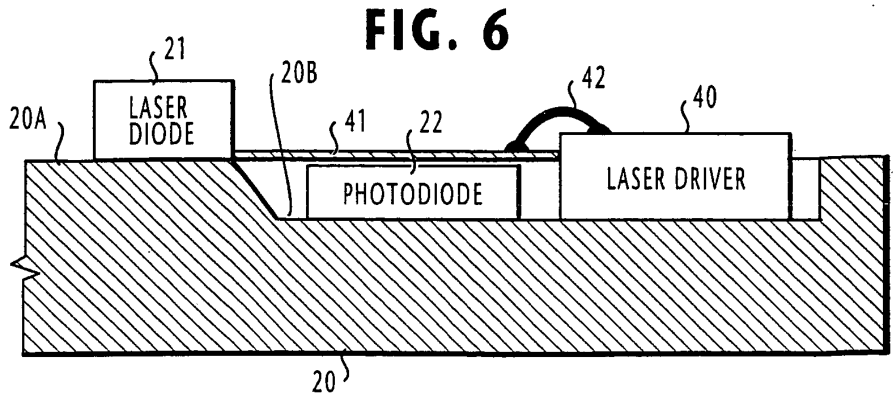

European Patent Office

# EUROPEAN SEARCH REPORT

Application Number
EP 03 02 4388

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,X | PATENT ABSTRACTS OF JAPAN vol. 2000, no. 12, 3 January 2001 (2001-01-03) -& JP 2000 269584 A (NEC CORP), 29 September 2000 (2000-09-29) * abstract * * paragraph [0006]; figure 1 * --- | 1,3,5 | H01S5/022 |
| Y | US 4 692 207 A (BOUADMA NOUREDDINE ET AL) 8 September 1987 (1987-09-08) * column 1 - column 5; figures 1,2 * --- | 1 | |
| Y | US 4 297 653 A (SCIFRES DONALD R ET AL) 27 October 1981 (1981-10-27) * abstract; figures 1-5 * * column 1 - column 7 * --- | 2,4,6-9 | |
| Y | EP 0 607 700 A (SHARP KK) 27 July 1994 (1994-07-27) * column 22, line 7 - line 30; figures 23,24 * --- | 1,2,4,6 | TECHNICAL FIELDS SEARCHED (Int.Cl.7) |
| Y | US 4 845 723 A (HEINEN JOCHEN ET AL) 4 July 1989 (1989-07-04) * abstract; figures 1,2 * * column 1 - column 4 * ----- | 7-9 | H01S |

The present search report has been drawn up for all claims

| Place of search | Date of completion of the search | Examiner |
|---|---|---|
| MUNICH | 10 February 2004 | Meacher, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 03 02 4388

This annex lists the patent family members relating to the patent documents cited in the above-mentioned European search report.
The members are as contained in the European Patent Office EDP file on
The European Patent Office is in no way liable for these particulars which are merely given for the purpose of information.

10-02-2004

| Patent document cited in search report | Publication date | Patent family member(s) | Publication date |
|---|---|---|---|
| JP 2000269584 A | 29-09-2000 | NONE | |
| US 4692207 A | 08-09-1987 | FR 2588701 A1 | 17-04-1987 |
| | | EP 0222639 A1 | 20-05-1987 |
| | | JP 62089391 A | 23-04-1987 |
| US 4297653 A | 27-10-1981 | JP 55145386 A | 12-11-1980 |
| EP 0607700 A | 27-07-1994 | JP 3074092 B2 | 07-08-2000 |
| | | JP 6314847 A | 08-11-1994 |
| | | JP 3084173 B2 | 04-09-2000 |
| | | JP 6334269 A | 02-12-1994 |
| | | JP 3022059 B2 | 15-03-2000 |
| | | JP 6350131 A | 22-12-1994 |
| | | JP 6196817 A | 15-07-1994 |
| | | CA 2112343 A1 | 25-06-1994 |
| | | CN 1093837 A ,B | 19-10-1994 |
| | | DE 69326136 D1 | 30-09-1999 |
| | | DE 69326136 T2 | 24-02-2000 |
| | | EP 0607700 A2 | 27-07-1994 |
| | | US 5557116 A | 17-09-1996 |
| US 4845723 A | 04-07-1989 | DE 3870651 D1 | 11-06-1992 |
| | | EP 0279404 A2 | 24-08-1988 |
| | | JP 1209776 A | 23-08-1989 |

EPO FORM P0459

For more details about this annex : see Official Journal of the European Patent Office, No. 12/82